(19) Europäisches Patentamt
European Patent Office
Office européen des brevets

(11) **EP 3 546 987 B1**

(12) **EUROPÄISCHE PATENTSCHRIFT**

(45) Veröffentlichungstag und Bekanntmachung des Hinweises auf die Patenterteilung:
**05.07.2023 Patentblatt 2023/27**

(21) Anmeldenummer: **19161864.4**

(22) Anmeldetag: **11.03.2019**

(51) Internationale Patentklassifikation (IPC):
**G01V 11/00** (2006.01)   **G01R 31/08** (2020.01)

(52) Gemeinsame Patentklassifikation (CPC):
**G01V 11/00; G01R 31/083**

(54) **VERFAHREN ZUR FEINORTUNG EINES KABELFEHLERS EINES ERDVERLEGTEN KABELS**

METHOD FOR DETERMINING THE PRECISE LOCATION OF A CABLE FAULT IN A BURIED CABLE

PROCÉDÉ DE LOCALISATION PRÉCISE D'UNE DÉFAILLANCE DANS UN CÂBLE ENTERRÉ

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **26.03.2018 AT 802018**

(43) Veröffentlichungstag der Anmeldung:
**02.10.2019 Patentblatt 2019/40**

(73) Patentinhaber: **BAUR GmbH**
**6832 Sulz (AT)**

(72) Erfinder:
• **JENNY, Martin**
**6850 Dornbirn (AT)**
• **HERPERTZ, Peter**
**6835 Muntlix (AT)**
• **BAUR, Martin**
**6832 Röthis (AT)**

(74) Vertreter: **Torggler & Hofmann Patentanwälte - Rankweil**
**Torggler & Hofmann Patentanwälte GmbH & Co KG**
**Hörnlingerstraße 3**
**Postfach 5**
**6830 Rankweil (AT)**

(56) Entgegenhaltungen:
**DE-A1-102010 013 613**

• **CHEUNG GILBERT ET AL: "Technics of locating underground cable faults inside conduits", 2016 INTERNATIONAL CONFERENCE ON CONDITION MONITORING AND DIAGNOSIS (CMD), IEEE, 25. September 2016 (2016-09-25), Seiten 619-622, XP033013539, DOI: 10.1109/CMD.2016.7757954 [gefunden am 2016-11-28]**
• **MEGGER: "MPP1000 Pinpointer", INTERNET CITATION, 3. Mai 2011 (2011-05-03), Seiten 1-2, XP002714290, Gefunden im Internet: URL:http://web.archive.org/web/20110315000 000*/http://www.techrentals.com.au/uploads /MEG_MPP1002-FAULT_PP.pdf [gefunden am 2013-10-04]**
• **HAO T ET AL: "Condition assessment of the buried utility service infrastructure", TUNNELLING AND UNDERGROUND SPACE TECHNOLOGY, ELSEVIER SCIENCE PUBLISHING, NEW YORK,NY, US, Bd. 28, 31. Oktober 2011 (2011-10-31), Seiten 331-344, XP028452361, ISSN: 0886-7798, DOI: 10.1016/J.TUST.2011.10.011 [gefunden am 2011-11-16]**

**Beschreibung**

Die Erfindung bezieht sich auf ein Verfahren zur Feinortung eines Kabelfehlers eines erdverlegten Kabels zur Übertragung von elektrischer Energie, wobei zur Ermittlung eines präzisen Fehlerorts des Kabelfehlers auf der Basis einer zuvor durch eine Vorortung ermittelten ungefähren Position des Kabelfehlers mittels einer mobilen Feinortungseinrichtung jeweilige Abstände einer den Kabelfehler bildenden defekten Stelle des Kabels von jeweiligen aktuellen Positionen der mobilen Feinortungseinrichtung ermittelt werden, wobei zur Bestimmung eines jeweiligen Abstandsmesswerts für den Abstand des präzisen Fehlerorts von der jeweiligen aktuellen Position der mobilen Feinortungseinrichtung Stoßspannungsimpulse in das Kabel eingespeist werden und von der mobilen Feinortungseinrichtung die Zeitdifferenz zwischen einem, von einem der Stoßspannungsimpulse hervorgerufenen, elektromagnetischen Impuls, der mittels eines elektromagnetischen Sensors der mobilen Feinortungseinrichtung detektiert wird, und einem durch einen von diesem Stoßspannungsimpuls ausgelösten Überschlag beim Kabelfehler hervorgerufenen akustischen Impuls, der mittels eines Mikrophons detektiert wird, gemessen wird und von der mobilen Feinortungseinrichtung aus dieser Zeitdifferenz der jeweilige Abstandsmesswert bestimmt wird.

Bei erdverlegten Kabeln zur Übertragung von elektrischer Energie können Fehler auftreten, welche eine Reparatur des Kabels im Bereich der defekten Stelle erforderlich machen. Es kann sich hierbei um Nieder-, Mittel- oder Hochspannungskabel handeln. Um die Reparatur durchführen zu können, ist es zunächst erforderlich, den Kabelfehler zu orten. Es wird der vertikal oberhalb des Kabelfehlers liegende Ort (="Fehlerort") gesucht, an welchem die Grabung durchgeführt wird, um auf die Stelle des Kabels zu stoßen, an welcher sich der Kabelfehler befindet. Verfahren sind hierzu bekannt.

Bei bekannten Verfahren zur Ortung von Kabelfehlern erfolgt zunächst eine Vorortung (Grobortung). Ein Beispiel hierfür ist die Sekundär-Mehrfachimpulsmethode, bei welcher es sich um ein Hochspannungs-Messverfahren handelt, welches für hochohmige Kabelfehler geeignet ist. Zur Ortung eines Kabelfehlers werden eine erste Reflektion eines Spannungspulses am Kabelende und eine zweite Reflektion durch einen Durchschlag an der defekten Stelle erfasst. Daneben sind weitere Verfahren zur Vorortung bekannt, z.B. Decay und ICM.

Als Ergebnis einer solchen Vorortung erhält man die Kabellänge zwischen dem Ort der Einspeisung des Vorortungssignals und der defekten Stelle des Kabels. Bei bekannter Kabeltrasse (=Verlauf des Kabels im Erdreich) kann damit die Position des Kabelfehlers bestimmt werden. Für die Kabeltrasse stehen entweder Geo-Daten zur Verfügung oder eine Bestimmung der Verlegestrecke des erdverlegten Kabels ist erforderlich. Solche Bestimmungen der Verlegestrecke (=des Kabelverlaufs) werden beispielsweise durch Einspeisen einer Tonfrequenz in das Erdkabel und eine oberirdisch entlang der Kabeltrasse geführte Suchspule durchgeführt.

Allerdings liefern die bekannten Verfahren zur Vorortung nur eine ungefähre Position des Kabelfehlers. Ein Grund hierfür ist insbesondere, dass es bei der Verlegung eines Kabels entlang der Kabeltrasse zu mehr oder weniger großen Abweichungen vom kürzesten Verlauf kommt. So kann die Verlegetiefe variieren, es können Kabelschlaufen vorhanden sein, usw. Insgesamt ergibt sich eine Ungenauigkeit der Vorortung des Kabelfehlers, welche meist im Bereich von 1% bis 10% der Länge des Kabels zwischen der Stelle des Einspeisens des Messsignals und dem Kabelfehler beträgt. Je nach Länge dieser Strecke kann somit die Abweichung zwischen dem präzisen Fehlerort des Kabelfehlers und der durch die Vorortung ermittelten ungefähren Position des Kabelfehlers im Bereich von einigen Metern bis einigen hundert Metern liegen.

Es ist auch bereits bekannt, die ermittelte ungefähre Position des Kabelfehlers auf einer Karte anzuzeigen. Die Vorortung erfolgt mittels einer üblicherweise in einem Messwagen sich befindenden Vorortungseinrichtung, die sich im Bereich einer Kabelstation befindet, von der eine Reihe von Kabeln ausgehen. Deren Verläufe sind als sogenannte "GIS-Daten" bekannt und können in der Vorortungseinrichtung gespeichert sein. Nachdem der Nutzer den Anfang des Kabels eingegeben hat, an welchem die Vorortung erfolgt, kann nach Ermittlung des Abstands des Kabelfehlers eine ungefähre Position des Kabelfehlers in einer auf der Anzeigeeinheit der Vorortungseinrichtung dargestellten Karte angezeigt werden. Die Vorortungseinrichtung kann auch einen GPS-Empfänger aufweisen, sodass auch die Position des Messwagens in der Karte angezeigt werden kann. Daraufhin kann sich die die Fehlerortung durchführende Person mittels Satellitennavigation zur ungefähren Position des Kabelfehlers begeben.

Um dann auf Basis der zuvor durchgeführten Vorortung (Grobortung) den präzisen Fehlerort des Kabelfehlers zu ermitteln, damit an diesem Ort im weiteren Verlauf die Grabarbeiten durchgeführt werden können, ist ein akustisches Feinortungs-Verfahren bekannt. Hierbei werden mittels eines Stoßspannungsgenerators Stoßspannungsimpulse in das Kabel eingespeist. Diese hochenergetischen Impulse verursachen einen sich im Kabel ausbreitenden Spannungsimpuls, der an der defekten Stelle zu einem Durchschlag führt. Dabei wird ein in der Umgebung des Kabelfehlers mit einem Bodenmikrophon detektierbares akustisches Signal erzeugt. Es kann nunmehr mit dem Bodenmikrophon der Ort der höchsten Amplitude des Durchschlaggeräusches gesucht werden, um den Fehlerort des Kabelfehlers zu ermitteln. Bei jeder Messung wird das Bodenmikrophon auf dem Untergrund abgesetzt und auf den nächsten Stoßspannungsimpuls und das hierdurch ausgelöste akustische Signal gewartet. Eine Fehlersuche auf diese Weise ist allerdings sehr zeitaufwendig.

Eine Verbesserung dieses Verfahrens besteht darin, dass ein Abstand der defekten Stelle des Kabels von der aktuellen Position einer mobilen Feinortungseinrichtung bestimmt wird. Hierzu weist die mobile Feinortungseinrichtung zusätzlich zum Bodenmikrophon, welches zur Detektion des akustischen Signals dient, einen elektromagnetischen Sensor auf, mit dem der über das Kabel übertragene Stoßspannungsimpuls und das hierdurch auftretende elektromagnetische Feld detektiert wird. Zwischen diesem detektierten elektromagnetischen Signal und dem detektierten akustischen Signal liegt eine Zeitdifferenz, welche erfasst wird. Diese Zeitdifferenz entspricht der Zeit, welche der vom Durchschlag hervorgerufene Schall von der defekten Stelle bis zur mobilen Feinortungseinrichtung benötigt (wobei die Zeit der Ausbreitung des Stoßspannungsimpulses demgegenüber vernachlässigbar ist). Somit kann aus dieser ermittelten Zeitdifferenz ein Abstand der defekten Stelle von der aktuellen Position der mobilen Feinortungseinrichtung bestimmt werden. Dieser Abstand wird auf einer Anzeige der mobilen Feinortungseinrichtung angezeigt. Die den Kabelfehler ortende Person kann somit bei ihren sich wiederholenden Messungen feststellen, ob sich der Abstand zur defekten Stelle verringert. Wenn dieser Abstand ein Minimum aufweist, befindet sich die Person direkt über der defekten Stelle des Kabels, also am präzisen Fehlerort. Das Suchen des präzisen Fehlerorts wird dadurch bedeutend vereinfacht. Ein derartiges Verfahren geht beispielsweise aus CHEUNG GILBERT ET AL: "Technics of locating underground cable faults inside conduits", 2016 INTERNATIONAL CONFERENCE ON CONDITION MONITORING AND DIAGNOSIS (CMD), IEEE, 25. September 2016 (2016-09-25), Seiten 619-622 hervor.

Ein akustisches Feinortungs-Verfahren, bei welchem die Zeitdifferenz zwischen dem akustischen Signal und dem Stoßspannungsimpuls ausgewertet wird, um den Abstand zum Kabelfehler zu ermitteln, geht beispielsweise auch aus der EP 2 405 279 A2 hervor. Es geht in dieser Schrift um ein Verfahren, bei dem auch in sehr lauten Umgebungsbedingungen eine akustische Feinortung durchgeführt werden kann.

Neben Einrichtungen zur Fehlerortung, welche eingesetzt werden, nachdem ein Kabelfehler aufgetreten ist, ist auch ein sogenanntes "Online-Monitoring" zur permanenten Überwachung von Kabeln im Betrieb bekannt. Es werden hierzu fix montierte, stationäre Überwachungseinrichtungen eingesetzt. Ein Verfahren zur Fehlerortung mittels stationären, im Leitungsnetz entlang der einzelnen Kabelverläufe montierten Einheiten geht beispielsweise aus der DE 10 2010 013 613 A1 hervor. Die Einheiten weisen jeweils Sensoren zur Erfassung eines elektromagnetischen Impulses und eines akustischen Impulses auf und die Zeitdifferenz zwischen den erfassten Impulsen wird zur Ermittlung der Fehlerdistanz erfasst.

Aus der CN 105676074 A ist eine Einrichtung zum Online-Monitoring von in Form von Freileitungen verlegten Hochspannungsleitungen bekannt. Es werden Messeinheiten auf Hochspannungsmasten im Abstand von 5km bis 50km montiert, von denen im Fall eines Überschlags auftretende Wanderwellen detektiert werden. Mittels GPS erfolgt eine Zeitsynchronisation und an einer Basisstation wird die Zeitdifferenz zwischen dem Eintreffen der Wanderwellen ausgewertet, um die Position der defekten Stelle annähernd zu ermitteln.

Aufgabe der Erfindung ist es bei einem Verfahren zur Feinortung der eingangs genannten Art das Auffinden der präzisen Position des Kabelfehlers weiter zu vereinfachen. Erfindungsgemäß gelingt dies durch ein Verfahren mit den Merkmalen des Anspruchs 1.

Beim Verfahren der Erfindung wird mittels eines GPS-Empfängers der Feinortungseinrichtung die aktuelle Position der Feinortungseinrichtung erfasst, wodurch ein "Positionsmesswert" erhalten wird. Ein solcher Positionsmesswert wird an einer ersten und einer hierzu unterschiedlichen zweiten aktuellen Position der Feinortungseinrichtung erfasst. An der ersten und an der zweiten aktuellen Position der Feinortungseinrichtung wird im Weiteren jeweils der Abstand des präzisen Fehlerorts von der jeweiligen aktuellen Position der mobilen Feinortungseinrichtung erfasst, wodurch jeweils ein "Abstandsmesswert" erhalten wird. Mittels der ersten und zweiten Positionsmesswerte und der ersten und zweiten Abstandsmesswerte wird mindestens ein zuvor nicht bekannter möglicher Fehlerort bestimmt. Diese Bestimmung erfolgt dadurch, dass für einen möglichen Fehlerort dessen Abstand vom ersten Positionsmesswert dem ersten Abstandsmesswert und dessen Abstand vom zweiten Positionsmesswert dem zweiten Abstandsmesswert entsprechen muss.

Im Allgemeinen wird man durch die Messungen an zwei unterschiedlichen aktuellen Positionen der Feinortungseinrichtung als Ergebnis zwei mögliche Fehlerorte erhalten, von welchen einer dem tatsächlichen präzisen Fehlerort entspricht.

Sollten aber die beiden aktuellen Positionen der mobilen Feinortungseinrichtung, an denen die Positionsmesswerte und Abstandsmesswerte ermittelt worden sind, auf einer Geraden liegen, auf welcher auch der präzise Fehlerort liegt (bezogen auf eine Grundrissdarstellung), so wird als Ergebnis nur ein möglicher Fehlerort erhalten, der dann bereits dem präzisen Fehlerort entspricht. Auf einer Anzeige der Feinortungseinrichtung wird eine in der Feinortungseinrichtung gespeicherte Karte der Umgebung der ungefähren Position des Kabelfehlers oder ein von einer Kamera der mobilen Feinortungseinrichtung aufgenommenes Bild dargestellt. In dieser Karte oder in diesem Bild wird ein Zielort dargestellt, der dem so ermittelten präzisen Fehlerort entspricht. Der dargestellte Zielort zeigt dem Benutzer somit an, wo der tatsächliche Fehlerort liegt.

Wenn aus der an der ersten und zweiten aktuellen Position der Feinortungseinrichtung durchgeführten Ermittlung der Positionsmesswerte und Abstandsmesswerte zwei mögliche Fehlerorte resultieren, so wird an einer zur ersten und zweiten unterschiedlichen dritten aktuellen Position der Feinortungseinrichtung, welche nicht auf einer gemeinsamen Geraden mit der ersten und zweiten aktuellen Position der Feinortungseinrichtung liegt (bezogen auf eine Grundrissdarstellung), von der mobilen Feinortungseinrichtung ein dritter Positionsmesswert sowie ein dritter Abstandsmesswert für den Abstand des präzisen Fehlerorts von der dritten aktuellen Position der mobilen Feinortungseinrichtung ermittelt. Anhand des dritten Positionsmesswerts und des dritten Abstandsmesswert wird ermittelt, welcher der beiden zuvor bestimmten möglichen Fehlerorte dem präzisen Fehlerort entspricht, indem bestimmt wird, an welchem der beiden möglichen Fehlerorte der Abstand von der dritten aktuellen Position der Feinortungseinrichtung dem dritten Abstandsmesswert entspricht. Auf der Anzeige der Feinortungseinrichtung wird dann dieser präzise Fehlerort als Zielort angezeigt, und zwar in der auf der Anzeige dargestellten Karte oder im auf der Anzeige dargestellten, von der Kamera aufgenommenen Bild.

Durch das erfindungsgemäße Verfahren wird dem Benutzer somit direkt genau ein Zielort für den präzisen Fehlerort des Kabelfehlers in der Karte oder im Bild angezeigt, sodass sich dieser ohne Umschweife zu diesem Zielort bewegen kann.

Das Auffinden des präzisen Fehlerorts des Kabelfehlers, um dort Grabungsarbeiten zum Freilegen und Reparieren des Kabels durchzuführen, kann dadurch vereinfacht und beschleunigt werden.

Die Bestimmung des mindestens einen möglichen Fehlerorts, der bzw. einer von denen dann als Zielort auf der Anzeige der Feinortungseinrichtung dargestellt wird, kann somit vorteilhafterweise ohne Heranziehung des auf die Grundrissdarstellung bezogenen Verlaufs des Kabels erfolgen. Der Kabelverlauf selbst muss somit nicht unbedingt bekannt sein oder in der Feinortungseinrichtung gespeichert sein. Sollte der Kabelverlauf bekannt sein und in der Feinortungseinrichtung gespeichert sein, beispielsweise durch Übertragung aus einer GIS-Datenbank, so kann dieser Kabelverlauf zusätzlich in der in der Feinortungseinrichtung gespeicherten Karte oder im von der Kamera der Feinortungseinrichtung aufgenommenen Bild dargestellt werden, was für das Auffinden der präzisen Position des Kabelfehlers hilfreich sein kann. So kann der Benutzer möglicherweise, wenn nach den Messungen an der ersten und zweiten Position der Feinortungseinrichtung noch zwei mögliche Zielorte für die möglichen Fehlerorte angezeigt werden, unmittelbar erkennen, an welchem dieser möglichen Zielorte der tatsächliche präzise Fehlerort liegen muss. Wenn nach den Messungen an der ersten und zweiten aktuellen Position der Feinortungseinrichtung oder den Messungen an der ersten, zweiten und dritten aktuellen Position der Feinortungseinrichtung nur ein Zielort auf der Anzeige dargestellt wird, so kann dieser Zielort auf Konsistenz mit dem gespeicherten Kabelverlauf überprüft werden.

Weitere Vorteile und Einzelheiten der Erfindung werden im Folgenden anhand der beiliegenden Zeichnung erläutert. In dieser zeigen:

Fig. 1 eine schematische Darstellung der Feinortung;
Fig. 2 eine Prinzipdarstellung der Feinortungseinrichtung;
Fig. 3 eine Darstellung zur Veranschaulichung eines ersten Schritts zur Ermittlung von möglichen Fehlerorten des Kabelfehlers;
Fig. 4 eine Darstellung entsprechend Fig. 3 eines zweiten Schritts zur Ermittlung des präzisen Fehlerorts;
Fig. 5 eine Darstellung der Anzeige der Feinortungseinrichtung;
Fig. 6 eine Darstellung entsprechend Fig. 3 in einer anderen Messsituation;
Fig. 7 eine Prinzipdarstellung entsprechend Fig. 2 für eine modifizierte Ausführungsform der Erfindung;
Fig. 8 eine Darstellung der Anzeige der Feinortungseinrichtung gemäß dieser modifizierten Ausführungsform der Erfindung;
Fig. 9 eine Darstellung entsprechend Fig. 3 zur Veranschaulichung einer möglichen Berechnungsmethode.

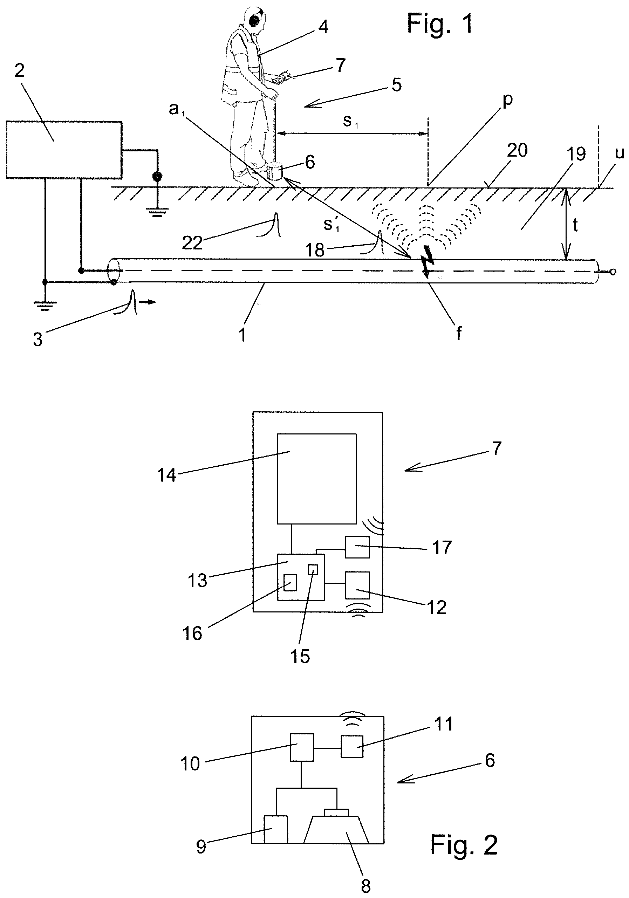

Ein erfindungsgemäßes Verfahren zur Feinortung wird im Folgenden anhand der Figuren beschrieben. Fig. 1 zeigt in schematischer Darstellung ein erdverlegtes Kabel 1 zur Übertragung von elektrischer Energie. Es kann sich um ein Niederspannungskabel (bis 1 kV), ein Mittelspannungskabel (1 kV bis 60 kV) oder ein Hochspannungskabel (> 60 kV, z.B. 110 kV, 220 kV oder 380 kV) handeln. An einer defekten Stelle f weist das Kabel einen Kabelfehler auf, insbesondere einen hochohmigen Kabelfehler oder einen intermittierenden Kabelfehler. Durch eine bekannte Vorortung (Grobortung) wurde eine ungefähre Position u des Kabelfehlers ermittelt.

Zur Feinortung (=Nachortung) des Kabelfehlers werden mittels eines an das Kabel angeschlossenen Stoßspannungsgenerators 2 Stoßspannungsimpulse 3 in das Kabel 1 eingespeist. Beispielsweise kann alle drei Sekunden die Einspeisung eines Stoßspannungsimpulses erfolgen. Die Abstände zwischen den einzelnen Stoßspannungsimpulsen können auch demgegenüber unterschiedliche Werte aufweisen, vorzugsweise liegen sie aber im Bereich zwischen 1 s und 10 s.

Die Höhe der Stoßspannungsimpulse kann auch von der Art des zu prüfenden Kabels abhängen. Im Allgemeinen wird die Höhe der Stoßspannungsimpulse über 1 kV liegen, beispielsweise bei Niederspannungskabeln im Bereich von 2 bis 5 kV. Bei Mittel- und Hochspannungskabeln wird die Höhe der Spannungsimpulse im Allgemeinen über 5 kV betragen, beispielsweise im Bereich von 10 bis 40 kV liegen. Günstigerweise kann die Höhe der Spannungsimpulse am Stoßspannungsgenerator eingestellt werden. Vorteilhafterweise wird vom Stoßspannungsgenerator zumindest ein einstellbarer Bereich von 2 kV bis 30 kV abgedeckt, wobei der abgedeckte Bereich auch größer sein kann.

Eine den Kabelfehler ortende Person 4 führt eine mobile Feinortungseinrichtung 5 mit sich. Diese umfasst im gezeigten Ausführungsbeispiel zwei getrennte Geräte, nämlich eine Erfassungseinheit 6 und eine Anzeigeeinheit 7. Die Datenübertragung zwischen der Erfassungseinheit 6 und der Anzeigeeinheit 7 erfolgt im Ausführungsbeispiel drahtlos, z.B. mittels Bluetooth, könnte aber auch drahtgebunden erfolgen.

Die Erfassungseinheit 6 weist ein Mikrophon 8 (das auch als "Bodenmikrophon" bezeichnet werden könnte) und einen elektromagnetischen Sensor 9 auf. Vom Mikrophon 8 und vom elektromagnetischen Sensor 9 abgegebene Signale werden von einem analogen Schaltkreis erfasst, A/D-gewandelt und einer Mikroprozessoreinheit zugeführt. Der analoge Schaltkreis, der A/D-Wandler und die Mikroprozessoreinheit sind in Fig. 2 schematisch als elektronische Signalverarbeitungseinheit 10 dargestellt. Im Weiteren werden die Daten mittels eines Senders 11 an einen Empfänger 12 der Anzeigeeinheit 7 übertragen. Die empfangenen Daten werden in einer Mikroprozessoreinheit 13 ausgewertet und von der Mikroprozessoreinheit 13 wird eine Anzeige 14 angesteuert. In der Mikroprozessoreinheit 13 sind schematisch ein Mikroprozessor 15 und ein Speicher 16 angedeutet. Die Mikroprozessoreinheit 13 wird im Allgemeinen weitere Bauteile aufweisen, welche in Fig. 2 nicht dargestellt sind.

Die Erfassungseinheit 6 könnte auch insgesamt als "Bodenmikrophon" bezeichnet werden.

Im Weiteren weist die Anzeigeeinheit 7 einen mit der Mikroprozessoreinheit 13 verbundenen GPS-Empfänger 17 zum Empfang von GPS-Signalen auf.

Wenn von der Anzeigeeinheit 7 auch Daten an die Erfassungseinheit 6 übertragen werden sollen, was im Allgemeinen zweckmäßig sein wird, so werden der Sender 11 und der Empfänger 12 jeweils als Sende-Empfangseinheit ausgebildet. Im Falle der drahtgebundenen Datenübermittlung könnten der Sender 11 und der Empfänger 12 auch entfallen. Es könnte dann auch nur eine Mikroprozessoreinheit entweder in der Anzeigeeinheit 7 oder in der Erfassungseinheit 6 vorgesehen sein, welche mindestens einen Mikroprozessor 15 und einen Speicher 16 aufweist.

Bei der Anzeigeeinheit kann es sich um ein Smartphone oder ein Tablet handeln. Es kann ein kommerziell erhältliches Smartphone oder Tablet eingesetzt werden, welches entsprechend eingerichtet ist. Die Anzeigeeinheit kann aber auch speziell für diese Anwendung ausgebildet sein.

In einer modifizierten Ausführungsform könnten die Erfassungseinheit 6 und die Anzeigeeinheit 7 auch zu einem gemeinsamen Gerät verbunden sein.

Vom Mikrophon empfangene Signale können an einen Kopfhörer und/oder Lautsprecher ausgegeben werden, sodass der Benutzer ein akustisches Feedback erhält.

Um die Feinortung des Kabelfehlers durchzuführen, werden mit dem Stoßspannungsgenerator 2 sich wiederholende Stoßspannungsimpulse 3 in das Kabel 1 eingespeist. Die Stoßspannungsimpulse 3 führen jeweils zu einem Durchschlag an der defekten Stelle f des Kabels 1, wodurch ein akustisches Signal in Form eines akustischen Impulses 18 erzeugt wird. Dieser akustische Impuls 18 breitet sich in alle Richtungen im das Kabel 1 umgebenden Erdreich 19 aus.

Wenn ein in das Kabel 1 eingespeister Stoßspannungsimpuls 3 den Bereich unterhalb der mobilen Feinortungseinrichtung 5 passiert, so wird das hierdurch hervorgerufene elektromagnetische Signal vom elektromagnetischen Sensor 9 als elektromagnetischer Impuls detektiert. Dieser detektierte elektromagnetische Impuls wird von der Mikroprozessoreinheit 13 als erster Trigger herangezogen, welcher eine Zeitmessung auslöst. Wenn vom Mikrophon 8 der akustische Impuls 18, welcher durch den vom Stoßspannungsimpuls ausgelösten Durchschlag hervorgerufen worden ist, empfangen wird und ein entsprechendes Signal an die Mikroprozessoreinheit 13 ausgegeben wird, so wird dies von der Mikroprozessoreinheit 13 als zweites Triggersignal herangezogen, welches die Zeitmessung beendet. Aus der verstrichenen Zeit •t zwischen dem ersten und dem zweiten Triggersignal wird der Abstand s1' der im Erdreich liegenden defekten Stelle f des Kabels 1 von der aktuellen Position der Feinortungseinrichtung 5 bestimmt. Es kann hierbei die Laufzeit des Stoßspannungsimpulses zwischen dem Bereich der aktuellen Position der mobilen Feinortungseinrichtung 5 und der defekten Stelle f bzw. die Ausbreitungszeit des durch den Stoßspannungsimpuls hervorgerufenen, vom elektromagnetischen Sensor 9 detektierten elektromagnetischen Impulses vernachlässigt werden, da die Ausbreitungsgeschwindigkeit vA des akustischen Impulses, also die Schallgeschwindigkeit im Erdreich 19, wesentlich geringer ist. Der Abstand s1' bestimmt sich somit zu:

$$s1' = vA \cdot \Delta t$$

Diese Bestimmung des Abstands s1' der tatsächlichen defekten Stelle f des Kabels 1 von der aktuellen Position der mobilen Feinortungseinrichtung 5 ist bekannt und wird auch als "Koinzidenzmethode" bezeichnet.

Mit der Feinortungseinrichtung 5 wird der präzise Fehlerort p des Kabelfehlers ermittelt. Es handelt sich um die Stelle auf dem Boden 20 vertikal oberhalb der tatsächlichen defekten Stelle f des Kabels. In einer Grundrissdarstellung fallen der präzise Fehlerort p und die tatsächliche defekten Stelle f des Kabels somit zusammen.

An diesem präzisen Fehlerort p sollen im weiteren Verlauf die Grabungsarbeiten zur Freilegung der defekten Stelle f des Kabels 1 durchgeführt werden.

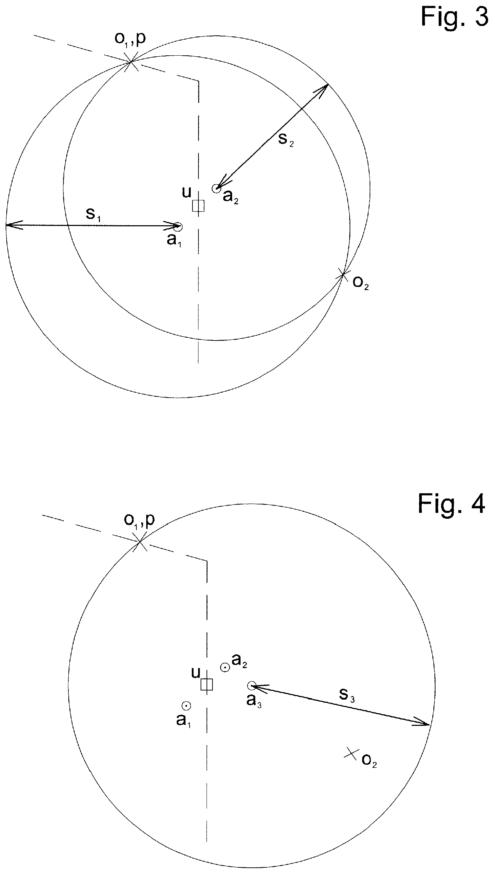

Die Ermittlung des präzisen Fehlerorts p wird im Folgenden anhand der Fig. 3 und 4 beschrieben, welche Grundrissdarstellungen sind.

Es wird zunächst an einer ersten aktuellen Position der mobilen Feinortungseinrichtung 5 mittels des GPS-Empfängers 17 der mobilen Feinortungseinrichtung 5 ein Positionsmesswert a1 für diese aktuelle Position erfasst. Außerdem wird an dieser aktuellen Position der mobilen Feinortungseinrichtung 5 ein Abstandsmesswert s1 für den Abstand des präzisen Fehlerorts p von der aktuellen Position der Feinortungseinrichtung 5 ermittelt. Näherungsweise kann hierzu der Abstand s1' der tatsächlichen defekten Stelle f des Kabels 1 von der aktuellen Position a1 der mobilen Feinortungseinrichtung 5 herangezogen werden, der wie zuvor beschrieben bestimmt wird. Diese Näherung kann insbesondere bei größeren Entfernungen der defekten Stelle f des Kabels 1 von der aktuellen Position ausreichend sein. Insbesondere falls der Abstandsmesswert einen Mindestwert unterschreitet, kann ein Tiefenwert t (vgl. Fig. 1) für die Verlegungstiefe des Kabels 1 berücksichtigt werden. Für diesen Tiefenwert t kann beispielsweise eine übliche Verlegungstiefe des Kabels gespeichert sein und herangezogen werden, z.B. 0,5 m. Eine manuelle Eingabe ist ebenfalls möglich. Es wird unter Berücksichtigung des Tiefenwerts t ein gegenüber dem ermittelten Abstand s1' mehr oder weniger kleinerer Abstandsmesswert s1 bestimmt.

Der Mindestwert für s1', unterhalb von dem ein korrigierter Abstandsmesswert s1 bestimmt und herangezogen wird, kann beispielsweise 1,5 m betragen. Ein korrigierter Abstandsmesswert s1 könnte auch bei größeren Werten für s1' bestimmt und herangezogen werden.

In der Folge wird an einer zweiten aktuellen Position der mobilen Feinortungseinrichtung, welche sich von der ersten aktuellen Position unterscheidet, wiederum ein Positionsmesswert p2 und Abstandsmesswert a2 ermittelt.

Aus diesen beiden Positionsmesswerten und Abstandsmesswerten kann mindestens ein möglicher Fehlerort o1, o2 ermittelt werden. Die möglichen Fehlerorte o1, o2 liegen sowohl auf einem Kreis mit dem Radius s1 um den Mittelpunkt a1 sowie auf einem Kreis mit dem Radius s2 um den Mittelpunkt a2. Fig. 3 zeigt eine Situation, in der die ersten und zweiten aktuellen Positionen der Feinortungseinrichtung, an denen die Positionsmesswerte a1, a2 und Abstandsmesswerte s1, s2 ermittelt werden, nicht auf einer gemeinsamen Geraden liegen. Der Kreis mit dem Radius s1 und dem Mittelpunkt a1 und der Kreis mit dem Radius s2 und dem Mittelpunkt a2 schneiden sich dann an zwei Stellen, welche die möglichen Fehlerorte o1, o2 kennzeichnen. An einer dieser beiden Stellen der möglichen Fehlerorte o1, o2 liegt der tatsächliche präzise Fehlerort p.

In Fig. 3 ist im Weiteren mit einer gestrichelten Linie der Verlauf des Kabels 1 angedeutet (welcher möglicherweise nicht bekannt ist). Außerdem ist die im Vorortungsverfahren ermittelte ungefähre Position u des Kabelfehlers dargestellt.

In der Folge wird, wie dies in Fig. 4 dargestellt ist, an einer dritten aktuellen Position der Feinortungseinrichtung, welche sich von der ersten und zweiten Position unterscheidet und mit diesen nicht auf einer gemeinsamen Geraden liegt, wiederum der Positionsmesswert a3 und der Abstandsmesswert s3 ermittelt. Derjenige der möglichen Fehlerorte o1, o2, welcher auf dem Kreis mit Radius s3 um den Mittelpunkt a3 liegt, kann somit als der präzise Fehlerort p identifiziert werden. Aufgrund von möglichen Messfehlern kann eine erlaubte Abweichung vorgesehen werden, innerhalb von der ein möglicher Fehlerort o1, o2 immer noch als auf dem Kreis mit Radius s3 und Mittelpunkt a3 liegend angesehen wird.

In Fig. 4 ist wiederum mit einer gestrichelten Linie der Verlauf des Kabels 1 angedeutet und die ungefähre Position des Kabelfehlers ist dargestellt.

Dieser mögliche Fehlerort o1, der dem präzisen Fehlerort p entspricht, wird auf der Anzeige 14 der mobilen Feinortungseinrichtung 5 als Zielort z dargestellt, und zwar auf einer Karte, welche zuvor auf der Feinortungseinrichtung 5 gespeichert worden ist.

Bei der Karte handelt es sich wieder um eine Grundrissdarstellung, wobei die Karte auch ein Satellitenbild sein kann. Auch eine dreidimensionale Darstellung ist möglich.

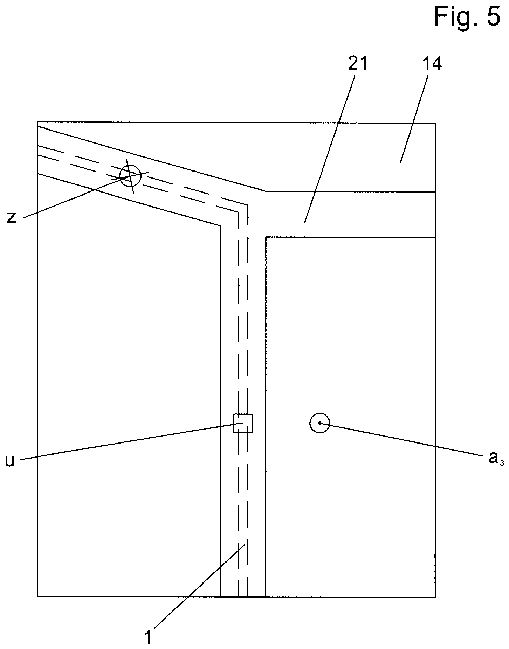

Die zuvor auf der Feinortungseinrichtung gespeicherte Karte umfasst also jedenfalls eine Umgebung der im Vorortungsverfahren ermittelten ungefähren Position u des Kabelfehlers (wobei die Karte vorzugsweise zumindest einen Bereich von 500 m um die in der Vorortung ermittelte ungefähre Position u des Kabelfehlers enthält). Die Karte kann von vorneherein in der Feinortungseinrichtung 5 gespeichert sein oder auch für den jeweiligen Anwendungsfall aus dem Internet heruntergeladen worden sein. Wie aus Fig. 5 ersichtlich, sind in der Karte Straßenverläufe 21 dargestellt.

Der Benutzer kann sich somit unmittelbar zum dargestellten Zielort z begeben. Es können dort noch weitere Messungen durchgeführt werden, z.B. Pegelmessungen der Lautstärke, um den präzisen Fehlerort p zu verifizieren.

Die aktuelle Position der mobilen Feinortungseinrichtung 5, entsprechend dem Positionsmesswert a3 ist vorzugsweise ebenfalls in der Karte dargestellt. Auch die durch die Vorortung ermittelte ungefähre Position u des Kabelfehlers kann dargestellt sein.

Außerdem kann in der Karte der geografische Verlauf des Kabels 1 (=die Verlegestrecke des Kabels 1), also die Grundrissdarstellung des Kabelverlaufs, dargestellt sein, falls dieser bekannt ist und in der Feinortungseinrichtung gespeichert ist. Hierzu können vorhandene Geo-Daten für den Kabelverlauf zuvor in den Speicher 16 eingespeichert worden sein, beispielsweise durch Übertragung aus einer GIS-Datenbank. Auch kann der Kabelverlauf vom Benutzer eingegeben worden sein. In Fig. 5 ist der Kabelverlauf durch gestrichelte Linien angedeutet.

Durch die Anzeige des Kabelverlaufs kann die korrekte Position des Zielorts z, also die korrekte Position des präzisen Fehlerorts p zusätzlich verifiziert werden. Auch erleichtert dies die Festlegung der Positionen, an denen die Messungen durchgeführt werden (also die Festlegung der Positionsmesswerte a1, a2, a3).

Bereits nach den Messungen an den Positionen der Feinortungseinrichtung entsprechend den Positionsmesswerten a1, a2 kann auf der Anzeige 14 der mobilen Feinortungseinrichtung 5 ein Inhalt analog Fig. 5 dargestellt werden. Es sind dann eben zwei mögliche Zielorte z entsprechend den möglichen Fehlerorten o1, o2 dargestellt. Günstigerweise ist auch die aktuelle Position entsprechend dem Positionsmesswert a2 dargestellt. Der Benutzer kann somit bereits vor der dritten durchgeführten Messung eine Orientierung erhalten, wo sich die möglichen Fehlerorte o1, o2 befinden. Falls auch der Kabelverlauf in der Anzeige dargestellt ist, kann der Benutzer bereits nach der zweiten Messung entscheiden, welcher der beiden dargestellten mögliche Zielorte z dem präzisen Fehlerort p entspricht.

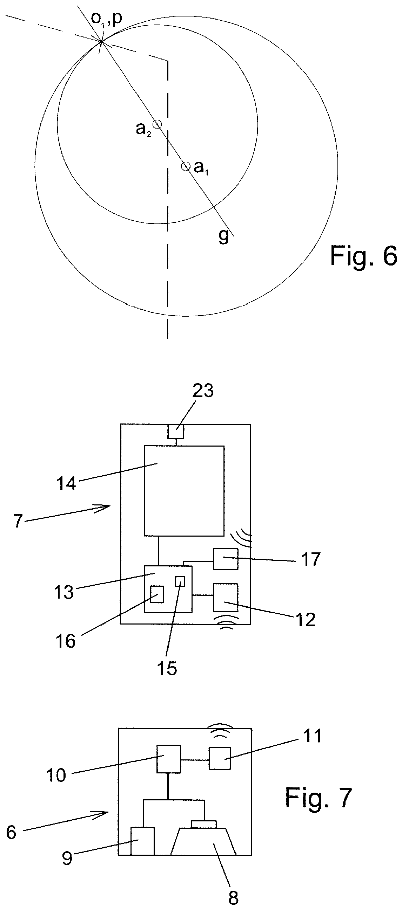

Fig. 6 zeigt die Situation, die sich auf Grund von an den Positionen entsprechend den Positionsmesswerten a1, a2 durchgeführten Messungen ergibt, wenn diese Positionsmesswerte a1, a2, insbesondere zufällig, auf einer Geraden g liegen, welche auch durch den präzisen Fehlerort p führt. Der Kreis um den Mittelpunkt a1 mit Radius s1 und der Kreis um den Mittelpunkt a2 mit Radius s2 haben hier nur einen Punkt gemeinsam, sodass sich nur ein möglicher Fehlerort o1 ergibt, der dem präzisen Fehlerort p entspricht. Es kann dann unmittelbar nach Durchführung der zweiten Messung eine Anzeige entsprechend Fig. 5 erfolgen (wobei die Position der Feinortungseinrichtung dem Positionsmesswert a2 entspricht).

Durch das erfindungsgemäße Verfahren wird somit für den Nutzer eine sehr zeitsparende und zuverlässige Feinortung ermöglicht.

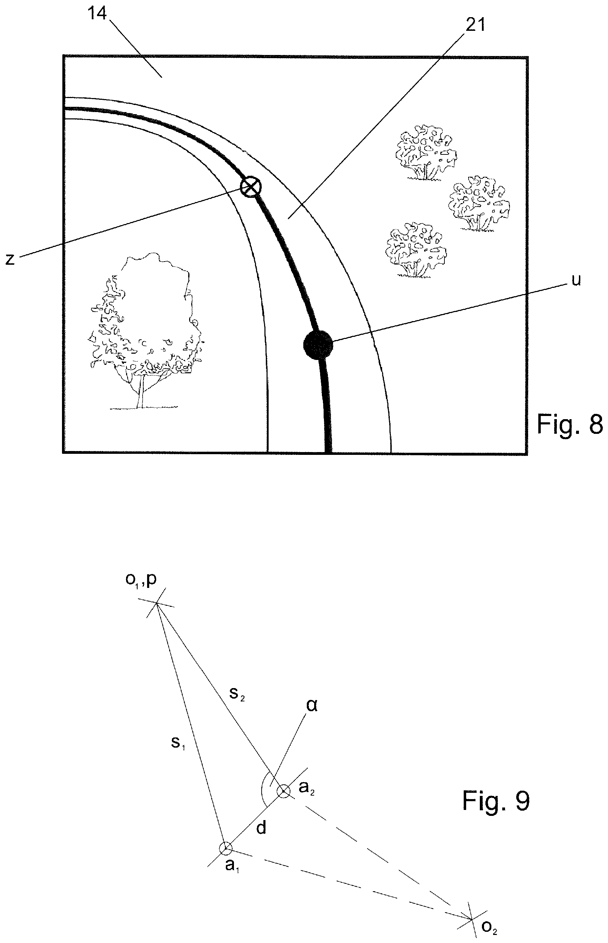

Eine modifizierte Ausführungsform der Erfindung wird im Folgenden anhand der Fig. 7 und 8 erläutert. Abgesehen von den im Folgenden beschriebenen Unterschieden entspricht die modifizierte Ausbildungsform der zuvor beschriebenen Ausführungsform und deren Beschreibung ist entsprechend anwendbar, zusammen mit den beschriebenen möglichen Modifikationen.

Der Unterschied zur zuvor beschriebenen Ausführungsform besteht darin, dass zur Darstellung des mindestens einen Zielorts z auf der Anzeige 14 der mobilen Feinortungseinrichtung 5 der Benutzer mit einer Kamera 23 der mobilen Feinortungseinrichtung 5 ein Bild (Foto) der Umgebung der ungefähren Position u des Kabelfehlers aufnimmt und der zumindest eine Zielort z in diesem Bild dargestellt wird, vgl. Fig. 8. Der mindestens eine Zielort z für den tatsächlichen Fehlerort wird also in das von der Kamera der Feinortungseinrichtung aufgenommene reelle Bild eingeblendet. Sollte sich der Zielort z (oder mindestens einer der Zielorte z) außerhalb des von der Kamera aufgenommenen Bildes befinden, so wird dies dem Benutzer entsprechend signalisiert.

Diese modifizierte Ausführungsform der Erfindung kann auch mit der zuvor beschriebenen Ausführungsform der Erfindung kombiniert werden, wobei für den Benutzer auswählbar ist, ob in der Anzeige die Karte oder ein von der Kamera aufgenommenes Bild dargestellt wird.

Unterschiedliche weitere Modifikationen der Erfindung sind denkbar und möglich. So könnten beispielsweise die zuvor durch die Mikroprozessoreinheit 13 beschriebenen Auswertungen auch ganz oder teilweise in der Mikroprozessoreinheit der Erfassungseinheit 6 durchgeführt werden.

Der GPS-Empfänger 17 könnte auch in der Erfassungseinheit 6 angeordnet sein.

Der elektromagnetische Sensor 9 könnte auch in der Anzeigeeinheit 7 angeordnet sein. Die Erfassungseinheit 6 könnte dann nur das Mikrophon 8 aufweisen.

Wie bereits erwähnt, könnte als Anzeigeeinheit 7 auch ein Smartphone oder Tablet eingesetzt werden. Die Anzeigeeinheit 7 könnte auch zwei oder mehr separate Geräte aufweisen. So könnte die Anzeigeeinheit 7 ein erstes Gerät mit einer Anzeige der Entfernung zur defekten Stelle des Kabels und/oder der Lautstärke des vom Durchschlag hervorgerufenen Geräuschs (wie herkömmlich) und ein zweites Gerät, welches z.B. ein Smartphone oder Tablet sein kann, mit einer Anzeige zur Darstellung des (mindestens einen) Zielorts in der Karte oder im von der Kamera aufgenommenen Bild aufweisen.

Eine Berechnungsmöglichkeit zur Bestimmung der möglichen Fehlerorte o1, o2 ist in Fig. 9 dargestellt. Aus den Abstandsmesswerten s1, s2 und dem Abstand a zwischen den Positionsmesswerten p1, p2 kann direkt der Winkel $\alpha$ ermittelt werden (mit dem Kosinussatz), wodurch die möglichen Fehlerorte o1, o2 erhalten werden. Die Berechnung kann für a2, a3; s2, s3 wiederholt werden, wodurch sich der präzise Fehlerort p als einer der beiden möglichen Fehlerorte o1, o2 ergibt.

Legende zu den Hinweisziffern:

| 1 | Kabel | g | Gerade |
|---|---|---|---|
| 2 | Stoßspannungsgenerator | o1, o2 | mögliche Fehlerorte |
| 3 | Stoßspannungsimpuls | p | präziser Fehlerort |
| 4 | Person | s1, s2 | Abstandsmesswerte |

| | | | |
|---|---|---|---|
| 5 | mobile Feinortungseinrichtung | t | Tiefenwert |
| 6 | Erfassungseinheit | u | ungefähre Position des Kabelfehlers |
| 7 | Anzeigeeinheit | | |
| 8 | Mikrophon | z | Zielort |
| 9 | elektromagnetischer Sensor | | |
| 10 | elektronische Signalverarbeitungseinheit | | |
| 11 | Sender | | |
| 12 | Empfänger | | |
| 13 | Mikroprozessoreinheit | | |
| 14 | Anzeige | | |
| 15 | Mikroprozessor | | |
| 16 | Speicher | | |
| 17 | GPS-Empfänger | | |
| 18 | akustischer Impuls | | |
| 19 | Erdreich | | |
| 20 | Boden | | |
| 21 | Straßenverlauf | | |
| 22 | elektromagnetischer Impuls | | |
| 23 | Kamera | | |
| a1, a2 | Positionsmesswerte für die aktuelle Position der Feinortungseinrichtung | | |
| f | defekte Stelle des Kabels | | |

**Patentansprüche**

1. Verfahren zur Feinortung eines Kabelfehlers eines erdverlegten Kabels (1) zur Übertragung von elektrischer Energie, wobei zur Ermittlung eines präzisen Fehlerorts (p) des Kabelfehlers auf der Basis einer zuvor durch eine Vorortung ermittelten ungefähren Position (u) des Kabelfehlers mittels einer mobilen Feinortungseinrichtung (5) jeweilige Abstände einer den Kabelfehler bildenden defekten Stelle (f) des Kabels (1) von jeweiligen aktuellen Positionen der mobilen Feinortungseinrichtung (5) ermittelt werden, wobei zur Bestimmung eines jeweiligen Abstandsmesswerts (s1, s2) für den Abstand des präzisen Fehlerorts (p) von der jeweiligen aktuellen Position der mobilen Feinortungseinrichtung (5) Stoßspannungsimpulse (3) in das Kabel (1) eingespeist werden und von der mobilen Feinortungs-einrichtung (5) die Zeitdifferenz ($\Delta$t) zwischen einem, von einem der Stoßspannungsimpulse hervorgerufenen, elektromagnetischen Impuls (22), der mittels eines elektromagnetischen Sensors (9) der mobilen Feinortungseinrichtung (5) detektiert wird, und einem durch einen von diesem Stoßspannungsimpuls ausgelösten Überschlag beim Kabelfehler hervorgerufenen akustischen Impuls (18), der mittels eines Mikrophons (8) detektiert wird, gemessen wird und von der mobilen Feinortungseinrichtung (5) aus dieser Zeitdifferenz ($\Delta$t) der jeweilige Abstandsmesswert (s1, s2) bestimmt wird, **dadurch gekennzeichnet, dass** an einer ersten und einer hierzu unterschiedlichen zweiten aktuellen Position der mobilen Feinortungseinrichtung (5) von der mobilen Feinortungseinrichtung (5) jeweils ein erster und ein zweiter Abstandsmesswert (s1, s2) für den jeweiligen Abstand des präzisen Fehlerorts (p) von der jeweiligen aktuellen Position der mobilen Feinortungseinrichtung (5) und jeweils mittels eines GPS-Empfängers (17) der mobilen Feinortungseinrichtung (5) ein erster und ein zweiter Positionsmesswert (a1, a2) für die jeweilige aktuelle Position der mobilen Feinortungseinrichtung (5) ermittelt wird und anhand der ersten und zweiten Positionsmesswerte (a1, a2) und der ersten und zweiten Abstandsmesswerte (s1, s2) mindestens ein zuvor nicht bekannter möglicher Fehlerort (o1,o2) dadurch bestimmt wird, dass der Abstand des möglichen Fehlerorts (o1,o2) von der ersten aktuellen Position der mobilen Feinortungseinrichtung (5) dem ersten Abstandsmesswert (s1) und der Abstand des möglichen Fehlerorts (o1,o2) von der zweiten aktuellen Position der mobilen Feinortungseinrichtung (5) dem zweiten Abstandsmesswert (s2) entspricht, und dass für den Fall, dass auf diese Weise nur ein möglicher Fehlerort (o1) erhalten wird, dieser dem präzisen Fehlerort (p) entspricht und auf einer Anzeige (14) der mobilen Feinortungseinrichtung (5) in einer in der mobilen Feinortungseinrichtung (5) gespeicherten Karte der Umgebung der ungefähren Position (u) des Kabelfehlers oder in einem von einer Kamera (23) der mobilen Feinortungseinrichtung (5) aufgenommenen Bild als Zielort (z) angezeigt wird und für den Fall, dass auf diese Weise zwei mögliche Fehlerorte (o1, o2) erhalten werden, an einer zur ersten und zweiten unterschiedlichen dritten aktuellen Position der mobilen Feinortungseinrichtung (5), welche nicht auf einer gemeinsamen Geraden mit der ersten und zweiten aktuellen Position der mobilen Feinortungseinrichtung (5) liegt, von der mobilen Feinortungseinrichtung (5) ein dritter Abstandsmesswert (s3) für den Abstand des präzisen Fehlerorts (p) von der aktuellen Position der mobilen Feinortungseinrichtung (5) und mittels des GPS-Empfängers (17) ein dritter Positionsmesswert (a3) für die aktuelle Position der mobilen Feinortungseinrichtung (5) ermittelt wird und anhand des dritten Positionsmesswerts (a3) und dritten Abstandsmesswerts (s3) bestimmt wird, welcher der beiden möglichen Fehlerorte (o1, o2) dem präzisen Fehlerort (p) entspricht, indem ermittelt wird, an welchem der beiden möglichen Fehlerorte (o1, o2) der Abstand von der dritten aktuellen Position der mobilen Feinortungseinrichtung (5) dem dritten Abstandsmesswert (s3) entspricht, und der so ermittelte präzise Fehlerort (p) auf der Anzeige (14) der mobilen Feinortungseinrichtung (5) in der Karte oder im von der Kamera (23) aufgenommenen Bild als Zielort (z) angezeigt wird.

2. Verfahren nach Anspruch 1, **dadurch gekennzeichnet, dass** zur Bestimmung des jeweiligen Abstandsmesswerts (s1, s2) zumindest im Fall des Unterschreitens eines Mindestwertes für den aus der Zeitdifferenz erhaltenen Wert (s1') für den Abstand der defekten Stelle (f) des Kabels (1) von der jeweiligen aktuellen Position der mobilen Feinortungseinrichtung (5) ein Tiefenwert (t) für die Verlegungstiefe des Kabels (1) berücksichtigt wird, sodass der Abstandsmesswert (s1, s2) für den Abstand des auf dem Boden vertikal oberhalb der defekten Stelle (f) liegenden präzisen Fehlerorts (p) des Kabelfehlers von der aktuellen Position der mobilen Feinortungseinrichtung (5) kleiner als der aus Zeitdifferenz erhaltene Wert (s1') für den Abstand der defekten Stelle (f) von der jeweiligen aktuellen Position der mobilen Feinortungseinrichtung (5) ist.

3. Verfahren nach Anspruch 1 oder 2, **dadurch gekennzeichnet, dass** die Bestimmung des mindestens einen möglichen Fehlerorts (o1,o2) ohne Heranziehung des auf die Grundrissdarstellung bezogenen Verlauf des Kabels (1) erfolgt.

4. Verfahren nach einem der Ansprüche 1 bis 3, **dadurch gekennzeichnet, dass** eine Datenübertragung zwischen einer das Mikrophon (8) und den elektromagnetischen Sensor (9) aufweisenden Erfassungseinheit (6) der mobilen Feinortungseinrichtung (5) und einer die Anzeige (14) aufweisenden Anzeigeeinheit (7) der mobilen Feinortungseinrichtung (5) drahtlos erfolgt.

5. Verfahren nach einem der Ansprüche 1 bis 4, **dadurch gekennzeichnet, dass** die Erfassungseinheit (6) ein Smartphone oder Tablet aufweist oder von einem Smartphone oder Tablet gebildet wird.

6. Verfahren nach einem der Ansprüche 1 bis 5, **dadurch gekennzeichnet, dass** in der Karte auch die aktuelle Position der mobilen Feinortungseinrichtung (5) dargestellt wird.

## Claims

1. Method for precisely locating a cable fault in a buried cable (1) for transmitting electrical energy, wherein for determining a precise fault location (p) of the cable fault on the basis of an approximate position (u) of the cable fault previously determined by pre-location respective distances between a defective part (f) of the cable (1) forming the cable fault and respective current positions of a mobile precise-locating device (5) are determined by means of the mobile precise-locating device (5), wherein for determining a respective distance measurement value (s1, s2) for the distance between the precise fault location (p) and the respective current position of the mobile precise-locating device (5) surge voltage pulses (3) are fed into the cable (1) and the time difference ($\Delta t$) between an electromagnetic pulse (22) caused by one of the surge voltage pulses, which is detected by means of an electromagnetic sensor (9) of the mobile precise-locating device (5), and an acoustic pulse (18) caused by a flashover triggered by this surge voltage pulse at the cable fault, which is detected by means of a microphone (8), is measured by the mobile precise-locating device (5) and based on this time difference ($\Delta t$) the respective distance measurement value (s1, s2) is determined by the mobile precise-locating device (5), **characterised in that** at a first current position and a second current position, which is different from the first, of the mobile precise-locating device (5) a first and a second distance measurement value (s1, s2) are respectively determined by the mobile precise-locating device (5) for the respective distance between the precise fault location (p) and the respective current position of the mobile precise-locating device (5) and a first and a second position measurement value (a1, a2) are respectively determined by means of a GPS receiver (17) of the mobile precise-locating device (5) for the respective current position of the mobile precise-locating device (5) and on the basis of the first and second position measurement values (a1, a2) and the first and second distance measurement values (s1, s2) at least one previously unknown possible fault location (o1, o2) is determined **in that** the distance between the possible fault location (o1, o2) and the first current position of the mobile precise-locating device (5) corresponds to the first distance measurement value (s1) and the distance between the possible fault location (o1, o2) and the second current position of the mobile precise-locating device (5) corresponds to the second distance measurement value (s2), and **in that** in case only one possible fault location (o1) is obtained in this way, this corresponds to the precise fault location (p) and is displayed as a target location (z) on a display (14) of the mobile precise-locating device (5) in a map of the surroundings of the approximate position (u) of the cable fault, which is stored in the mobile precise-locating device (5) or in an image captured by a camera (23) of the mobile precise-locating device (5), and in case two possible fault locations (o1, o2) are obtained in this way, at a third current position of the mobile precise-locating device (5), which is different from the first and second positions and which is not on the same line as the first and second current positions of the mobile precise-locating device (5), a third distance measurement value (s3) is determined by the mobile precise-locating device (5) for the distance between the precise fault location (p) and the current position of the mobile precise-locating device (5) and a third position measurement value (a3) is determined by means of the GPS receiver (17) for the current position of the mobile precise-locating device (5) and on the basis of the third position measurement value (a3) and the third distance measurement value (s3) it is determined which of the two possible fault locations (o1, o2) corresponds to the precise fault location (p) by determining at which of the two possible fault locations (o1, o2) the distance from the third current position of the mobile precise-locating device (5) corresponds to the third distance measurement value (s3), and the precise fault location (p) determined in this way is displayed as a target location (z) on the display (14) of the mobile precise-locating device (5) in the map or in the image captured by the camera (23).

2. Method according to claim 1, **characterised in that** for determining the respective distance measurement value (s1, s2), at least in the event of falling below a minimum value for the value (s1') obtained based on the time difference for the distance between the defective part (f) of the cable (1) and the respective current position of the mobile precise-locating device (5), a depth value (t) for the installation depth of the cable (1) is taken into consideration, such that the distance measurement value (s1, s2) for the distance between the precise fault location (p) of the cable fault on the ground vertically above the defective part (f) and the current position of the mobile precise-locating device (5) is smaller than the value (s1') obtained based on the time difference for the distance between the defective part (f) and the respective current position of the mobile precise-locating device (5).

3. Method according to claim 1 or 2, **characterised in that** the at least one possible fault location (o1, o2) is determined without the use of the route of the cable (1) referenced in the plan view.

4. Method according to any of claims 1 to 3, **characterised in that** a data transmission between a detecting unit (6), comprising the microphone (8) and the electromagnetic sensor (9), of the mobile precise-locating device (5) and a display unit (7), comprising the display (14), of the mobile precise-locating device (5) occurs wirelessly.

5. Method according to any of claims 1 to 4, **characterised in that** the detecting unit (6) comprises a smartphone or tablet or is formed from a smartphone or tablet.

6. Method according to any of claims 1 to 5, **characterised in that** the current position of the mobile precise-locating device (5) is also shown in the map.

**Revendications**

1. Procédé de localisation précise d'un défaut de câble d'un câble enterré (1) servant à la transmission d'énergie électrique, procédé dans lequel, pour déterminer une position précise de défaut (p) du défaut de câble sur la base d'une position approximative (u) du défaut de câble déterminée préalablement par une prélocalisation, on détermine au moyen d'un dispositif mobile de localisation précise (5) des distances respectives d'un emplacement de défaut (f) du câble (1) formant le défaut de câble à partir de positions actuelles respectives du dispositif mobile de localisation précise (5), des impulsions de tension de choc (3) étant injectées dans le câble (1) pour déterminer une valeur de mesure de distance (s1, s2) respective pour la distance de la position précise de défaut (p) par rapport à la position actuelle respective du dispositif mobile de localisation précise (5), et le dispositif mobile de localisation précise (5) mesurant la différence temporelle (Δt) entre une impulsion électromagnétique (22) qui est provoquée par l'une des impulsions de tension de choc et qui est détectée au moyen d'un capteur électromagnétique (9) du dispositif mobile de localisation précise (5), et une impulsion acoustique (18) qui est provoquée par une décharge disruptive déclenchée par cette impulsion de tension de choc au niveau du défaut de câble et qui est détectée au moyen d'un microphone (8), et le dispositif mobile de localisation précise (5) déterminant la valeur de mesure de distance respective (s1, s2) à partir de cette différence temporelle (Δt), **caractérisé en ce qu'**en une première position actuelle du dispositif mobile de localisation précise (5), et en une deuxième position actuelle du dispositif mobile de localisation précise (5), différente de la première, le dispositif mobile de localisation précise (5) détermine respectivement une première et une deuxième valeur de mesure de distance (s1, s2) pour la distance respective de la position précise de défaut (p) par rapport à la position actuelle respective du dispositif mobile de localisation précise (5), et une première et une deuxième valeur de mesure de position (a1, a2) sont déterminées pour la position actuelle respective du dispositif mobile de localisation précise (5) à l'aide d'un récepteur GPS (17) du dispositif mobile de localisation précise (5), et, à l'aide des première et deuxième valeurs de mesure de position (a1, a2) et des première et deuxième valeurs de mesure de distance (s1, s2), au moins une position possible de défaut (o1, o2) non connue auparavant est déterminée du fait que la distance de la position possible de défaut (o1, o2) par rapport à la première position actuelle du dispositif mobile de localisation précise (5) correspond à la première valeur de mesure de distance (s1) et la distance de la positon possible de défaut (o1, o2) par rapport à la deuxième position actuelle du dispositif mobile de localisation précise (5) correspond à la deuxième valeur de mesure de distance (s2), et **en ce que,** dans le cas où seule une position possible de défaut (o1) est ainsi obtenue, celui-ci correspond la positon précise de défaut (p) et elle est affichée comme lieu cible (z) sur un affichage (14) du dispositif mobile de localisation précise (5) dans une carte de l'environnement de la position approximative (u) du défaut de câble qui est enregistrée dans le dispositif mobile de localisation précise (5) ou dans une image prise par une caméra (23) du dispositif mobile de localisation précise (5), et dans le cas où deux positions possibles de défaut (o1, o2) sont ainsi obtenues, une troisième valeur de mesure de distance (s3) pour la distance de la position précise de défaut (p) par rapport à la position actuelle du dispositif mobile de localisation précise (5) est déterminée par le dispositif mobile de localisation précise (5) en une troisième position actuelle du dispositif mobile de localisation précise (5) différente des première et deuxième positions actuelles et qui ne se trouve pas sur une ligne droite commune à la première et à la deuxième position actuelle du dispositif mobile de localisation précise (5), et une troisième valeur de mesure de position (a3) est déterminée au moyen du récepteur GPS (17) pour la position actuelle du dispositif mobile de localisation précise (5), et à l'aide de la troisième valeur de mesure de position (a3) et de la troisième valeur de mesure de distance (s3), on détermine laquelle des deux positions possibles de défaut (o1, o2) correspond à la position précise de défaut (p), en déterminant en laquelle des deux positions possibles de défaut (o1, o2) la distance de la troisième position actuelle du dispositif mobile de localisation précise (5) correspond à la troisième valeur de mesure de distance (s3), et la position précise de défaut (p) ainsi déterminée est affichée comme lieu cible (z) sur l'affichage (14) du dispositif mobile de localisation précise (5) dans la carte ou dans l'image prise par la caméra (23).

2. Procédé selon la revendication 1, **caractérisé en ce que** pour déterminer la valeur de mesure de distance respective (s1, s2), au moins dans le cas où la valeur (s1') obtenue à partir de la différence temporelle pour la distance entre l'emplacement de défaut (f) du câble (1) et la position actuelle respective du dispositif mobile de localisation précise (5) est inférieure à une valeur minimale, une valeur de profondeur (t) est prise en compte pour la profondeur de pose du câble (1), de sorte que la valeur de mesure de distance (s1, s2) pour la distance de la position précise de défaut (p) du défaut de câble située sur le sol verticalement au-dessus de l'emplacement de défaut (f) par rapport à la position actuelle du dispositif mobile de localisation précise (5) est inférieure à la valeur (s1') obtenue à partir de la différence temporelle pour la distance de l'emplacement de défaut (f) par rapport à la position actuelle respective du dispositif mobile de localisation précise (5).

3. Procédé selon la revendication 1 ou 2, **caractérisé en ce que** la détermination de ladite au moins une position possible de défaut (o1, o2) est réalisée sans utiliser le tracé du câble (1) par rapport au plan de masse.

4. Procédé selon l'une des revendications 1 à 3, **caractérisé en ce qu'**une transmission de données s'effectue sans fil entre une unité d'acquisition (6) du dispositif mobile de localisation précise (5), munie du microphone (8) et du capteur électromagnétique (9), et une unité d'affichage (7) du dispositif mobile de localisation précise (5) munie de l'affichage (14).

5. Procédé selon l'une des revendications 1 à 4, **caractérisé en ce que** l'unité de détection (6) comprend un smartphone ou une tablette, ou est constituée par un smartphone ou une tablette.

6. Procédé selon l'une des revendications 1 à 5, **caractérisé en ce que** la position actuelle du dispositif mobile de localisation précise (5) est également représentée sur la carte.

Fig. 1

Fig. 2

Fig. 3

Fig. 4

Fig. 5

Fig. 6

Fig. 7

Fig. 8

Fig. 9

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 2405279 A2
- DE 102010013613 A1

- CN 105676074 A

**In der Beschreibung aufgeführte Nicht-Patentliteratur**

- Technics of locating underground cable faults inside conduits. **CHEUNG GILBERT et al.** 2016 INTERNATIONAL CONFERENCE ON CONDITION MONITORING AND DIAGNOSIS (CMD). IEEE, 25. September 2016, 619-622